(19) Europäisches Patentamt
European Patent Office
Office européen des brevets

(11) **EP 3 311 107 B1**

(12) **EUROPÄISCHE PATENTSCHRIFT**

(45) Veröffentlichungstag und Bekanntmachung des Hinweises auf die Patenterteilung:
**24.04.2019 Patentblatt 2019/17**

(21) Anmeldenummer: **16729519.5**

(22) Anmeldetag: **07.06.2016**

(51) Int Cl.:
*G01D 18/00* (2006.01)   *G01D 5/20* (2006.01)
*G01R 31/02* (2006.01)   *G01R 31/28* (2006.01)
*G01B 7/30* (2006.01)

(86) Internationale Anmeldenummer:
**PCT/EP2016/062852**

(87) Internationale Veröffentlichungsnummer:
**WO 2016/202631 (22.12.2016 Gazette 2016/51)**

(54) **VERFAHREN UND SCHALTUNG ZUM ERKENNEN EINER OFFENEN RESOLVER-ERREGERLEITUNG**

METHOD AND CIRCUIT FOR DETECTING AN OPEN RESOLVER EXCITER LINE

PROCÉDÉ ET CIRCUIT POUR DÉTECTER UNE LIGNE D'EXCITATION OUVERTE D'UN RÉSOLVEUR

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **18.06.2015 DE 102015211224**

(43) Veröffentlichungstag der Anmeldung:
**25.04.2018 Patentblatt 2018/17**

(73) Patentinhaber: **Robert Bosch GmbH 70442 Stuttgart (DE)**

(72) Erfinder:
- **UNGERMANN, Michael 64285 Darmstadt (DE)**
- **LECHNER, Benjamin 75242 Neuhausen (DE)**
- **ZIRKEL, Daniel 75446 Wiernsheim-Serres (DE)**
- **RAICHLE, Daniel 71665 Vaihingen (DE)**

(56) Entgegenhaltungen:
EP-A1- 2 610 601    EP-A1- 2 657 667
DE-A1-102009 020 431    JP-A- 2012 098 188
JP-A- 2012 098 195

**Beschreibung**

Die Erfindung betrifft ein Verfahren zum Erkennen einer offenen Resolver-Erregerleitung und eine Schaltung zum Realisieren dieses Verfahrens.

Stand der Technik

Resolver dienen zum Ermitteln der Winkelstellung eines rotierenden Objekts, z.B. der Antriebswelle eines Motors. Im Stand der Technik gibt es verschiedene Resolvertypen. Grundsätzlich wird dabei mittels mindestens einer Spule ein sich änderndes magnetisches Feld erzeugt, und mittels mindestens einer weiteren Spule wird dieses Feld detektiert, wobei die Stärke der Kopplung zwischen den Spulen in Abhängigkeit von der zu messenden Position oder Winkelstellung variiert. Beim "Variable Reluctance Resolver" (VR-Resolver) beispielsweise kommt nur eine Erregerspule zum Einsatz und es gibt zwei Messspulen, die positionsabhängige Signale erzeugen. Die deutsche Patentanmeldung DE 10 2011 078 583 A1 offenbart beispielsweise eine Auswertung von Resolver-Sensorsignalen in einem Fahrzeug. Ein Resolver nimmt hierzu eine Drehbewegung eines Rotors auf, und ein Prozessorelement verarbeitet die sinus- bzw. kosinusförmigen Ausgangssignale des Resolver. JP2012098188 offenbart eine Vorrichtung zum Erkennen einer offenen Erregerleitung eines Resolvers.

Die Erfindung geht von einem solchen Resolver aus, wobei das Erregersignal sinusförmig ist und typischerweise eine Frequenz von 10 kHz hat. Die beiden Messspulen sind in der Regel orthogonal zueinander positioniert und werden als Sinus- und Kosinusspule bezeichnet. Mit den beiden Messsignalen ist der Winkel des Messobjekts eindeutig bestimmbar.

Das Erregersignal für die Erregerspule kann beispielsweise durch zwei Gegentaktendstufen bereitgestellt werden, je eine für die beiden Anschlüsse der Erregerspule. Die Ausgangssignale der beiden Endstufen sind dann um 180° zueinander phasenverschoben und das für die Erregerspule wirksame Erregersignal ist die Differenzspannung zwischen den Ausgängen der beiden Endstufen.

Es besteht aber auch die Möglichkeit, die Erregerspule durch nur eine Endstufe zu betreiben. Der zweite Anschluss der Erregerspule ist dann entweder direkt oder über einen Kondensator auf ein festes Potential, z. B. Massepotential gelegt.

An den Empfängerspulen entsteht ein Wechselspannungssignal mit derselben Frequenz wie das Erregersignal, dessen Amplitude jedoch entsprechend der Rotorlage moduliert ist, wobei das Signal an der Kosinusspule um 90° gegenüber dem Signal an der Sinusspule phasenverschoben ist.

Resolver werden häufig zur Regelung von permanenterregten Synchronmaschinen (PSM) und elektrisch erregten Synchronmaschinen (ESM) eingesetzt, die z.B. als Antrieb für Hybrid- und Elektrofahrzeuge Verwendung finden. Für eine solche Regelung ist die Kenntnis der aktuellen Rotorwinkellage notwendig. Bei der Regelung von Asynchronmaschinen (ASM) ist die Kenntnis der aktuellen Frequenz des Antriebs erforderlich.

Wegen ihrer Robustheit werden in Kraftfahrzeugen für diese Zwecke bevorzugt Resolver eingesetzt, auch wenn es alternative Sensoren gibt, z.B. digitale Winkelgeber oder Sensoren auf der Basis des Wirbelstromeffekts.

Für Sensoren im Automobilbereich sind Diagnosemöglichkeiten möglicher Fehler wünschenswert. Bei Resolvern, wie sie die vorliegende Anmeldung zum Gegenstand hat, ist ein möglicher, zu diagnostizierender Fehler eine offene Leitung im Erregerpfad des Resolvers, d.h. zumindest ein Anschluss der Erregerspule hat keine elektrische Verbindung zur Ansteuerung mehr, oder es liegt ein Kabelbruch innerhalb der Erregerspule vor.

Eine Möglichkeit, einen solchen Fehler zu diagnostizieren besteht darin, dass beide Empfängersignale (Sinus und Kosinus) nicht mehr vorhanden sind. Eine solche Diagnose reicht jedoch nicht aus, weil das Ausbleiben von Sinus- und Kosinussignal auch andere Ursachen haben kann, z.B. einen Kurzschluss in der Erregerleitung oder eine gleichzeitige Unterbrechung beider Empfängersignale.

Offenbarung der Erfindung

Das Verfahren zum Erkennen einer offenen Resolver-Erregerleitung umfasst zunächst eine permanente Überwachung der Funktion des Resolvers durch das Abgreifen der Signalspannungen von der Sinus- und der Kosinusspule und das Vergleichen der daraus errechneten vektoriellen Amplitude der Summe der Signalspannungen mit einem ersten Schwellwert. Erreicht dieses Signal den Schwellenwert nicht, so wird ein Diagnosemodus gestartet, bei dem die Erregerleitung für die Zeit von mindestens einer Erregerperiode über einen Vorwiderstand mit einer Gleichspannung beaufschlagt wird, und es wird während dieser Zeit die Spannungsdifferenz an den Anschlüssen der Erregerleitung gemessen. Die Erregerleitung wird als offen erkannt, wenn der Gleichspannungsanteil dieser Spannungsdifferenz größer als ein zweiter Schwellwert ist. Unter einer Erregerperiode wird insbesondere eine Periode des Erregersignals verstanden, welches üblicherweise sinusförmig ist.

Ein anderer Aspekt der Erfindung besteht in einer Schaltung, die dieses Verfahren realisiert. Die Schaltung geht aus von der zu untersuchenden Schaltung, die eine Steuervorrichtung mit einem Prozessor und einer Leistungsstufe zum Bereitstellen des Signals für die Erregerleitung umfasst, weiterhin die zu diagnostizierenden Erregerleitung zu der Erregerspule des Resolvers und die Signalleitungen für das Sinus- und Kosinussignal, die zurück zur Steuervorrichtung verlaufen. Die Schaltung umfasst weiterhin zwei AD-Wandler, die an die Anschlüsse für die Signalleitungen angeschlossen sind und deren Ausgänge von dem Prozessors lesbar und verarbeitbar sind.

Weiterhin umfasst die Schaltung vom Prozessor gesteuerte elektronische Schalter zum Aufschalten einer konstanten Spannung auf die beiden Ausgänge für das Erregersignal über einen Vorwiderstand und sie umfasst einen am Ausgang für das Erregersignal angeschlossenen dritten AD-Wandler, der mit dem Prozessors verbunden ist. Schließlich umfasst die Schaltung eine Anzeige- und/oder Speichereinrichtung zum Anzeigen und/oder Speicher der vom Prozessor identifizierten Informationen, in die das positive Erkennen einer offenen Erregerleitung des Resolvers und das Bezeichnen der offenen Leitung einbezogen sind.

Vorteile der Erfindung

Der Vorteil der Erfindung besteht darin, dass der zu diagnostizierende Fehler exakt von anderen Fehlern unterschieden werden kann (PinPointing-Diagnose). Die Diagnose ist auch sehr schnell, denn bereits nach wenigen Perioden des Erregresignals mit einer typischen Dauer von 0,1 ms liegt eine zuverlässige Fehlerdiagnose vor, und es können ggf. geeignete Maßnahmen ergriffen werden. Damit können insbesondere Anforderungen an Sensoren im Automobilbereich im Hinblick auf funktionelle Sicherheit wie auch im Hinblick auf OBD-Funktionalität (OBD = On Board Diagnose) erfüllt werden.

Vorteilhaft ist weiterhin, dass das erfindungsgemäße Verfahren mit minimaler Ergänzung der üblichen Hardware einer Resolveransteuerung realisiert werden kann.

Kurze Beschreibung der Zeichnungen

Fig. 1 zeigt eine Schaltung gemäß einem Ausführungsbeispiel der Erfindung.

Fig. 2 erläutert schematisch die Schritte zum Ausführen des Verfahrens gemäß einem Ausführungsbeispiel der Erfindung.

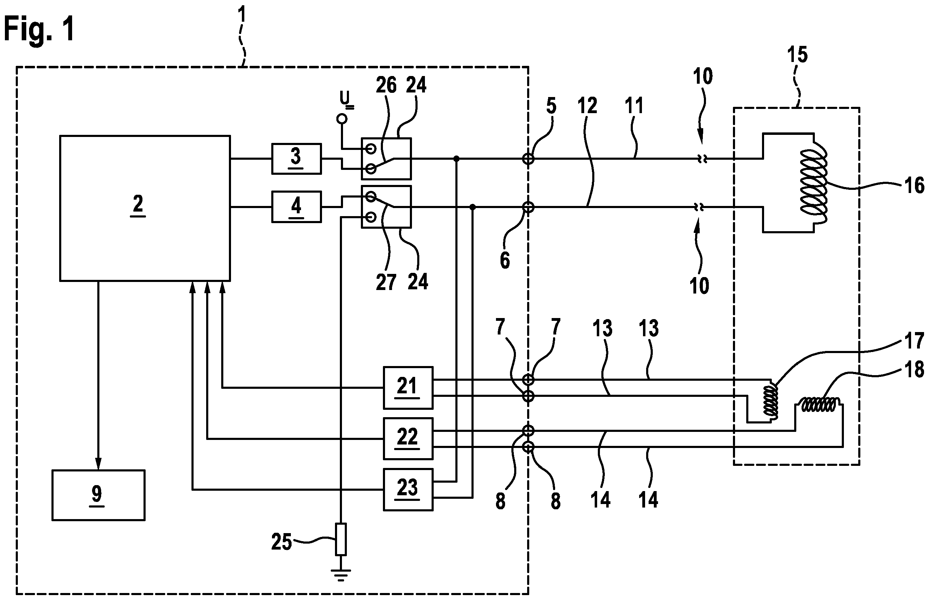

In Figur 1 steht die Steuervorrichtung 1 für den Resolver im Zentrum, die in die Steuereinrichtung für ein Fahrzeug integriert sein kann (hier nicht dargestellt). Sie weist einen Prozessor 2 auf (oder nutzt diesen mit), der den korrekten Ablauf aller zu steuernden Resolverfunktionen überwacht und auch ggf. Fehlfunktionen anzeigt.

Die Steuervorrichtung 1 steuert insbesondere die Leistungsstufen 3 und 4 zum Bereitstellen des sinusförmigen Erregersignals für die Erregerspule 16 des Resolvers 15 an den ersten Anschlüssen 5 und 6. An den zweiten Anschlüssen 7 und 8 gelangen die Signale der Sinusspule 17 und der Kosinusspule 18, die die momentane Winkelstellung des Messobjekts (z.B. der Welle des Motors) repräsentieren, zur Steuervorrichtung 1 und können nach Wandlung in den AD-Wandlern 21 und 22 als digitales Signal softwaremäßig weiter bearbeitet werden.

Die Resolver-Erregerleitungen 11 und 12 stellen die Verbindung von den ersten Anschlüssen der Steuervorrichtung 1 zum Resolver 15, nämlich zu dessen Erregerspule 16 dar. Diese Leitungen gilt es im Hinblick auf eine Unterbrechung zu überwachen, was in Figur 1 mit den potentiellen Unterbrechungen 10 angedeutet ist. Von der Sinusspule 17 und der Kosinusspule 18 des Resolvers 15 gehen die Signalleitungen 13 und 14 zu den zweiten Anschlüssen 7 und 8 der Steuervorrichtung 1.

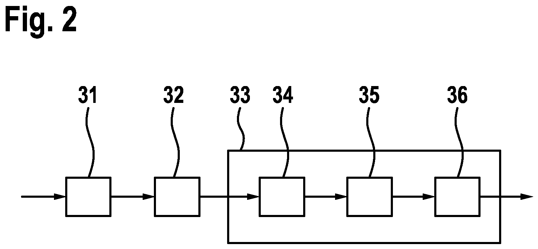

Das Verfahren zum Erkennen einer offenen Resolver-Erregerleitung (10) beginnt mit dem Schritt 31 (vgl. Fig. 2), bei dem an den zweiten Anschlüssen 7 und 8 die Resolversignale permanent gemessen und dahingehend vom Prozessor 2 ausgewertet werden, dass die Amplitude des Messsignals bestimmt wird, die sich aus der Summe des Quadrats des Signals $U_S$ der Sinusspule 17 und des Quadrats des Signals $U_C$ der Kosinusspule 18 ergibt. Diese Amplitude des Resolversignals $U_S^2 + U_C^2$ wird mit einem ersten Schwellenwert $C_{S1}$ verglichen (Schritt 32) und wenn dieser Schwellenwert unterschritten wird, d.h. wenn das Resolversignal ausbleibt, wird ein Diagnosemodus (Schritt 33) gestartet.

Im Diagnosemodus 33 werden die Erregerleitungen 11 und 12 und die Erregerspule 16 näher untersucht, indem versucht wird, für eine kurze Zeit, z.B. für eine Erregerperiode, durch sie einen Gleichstrom zu leiten. Hierfür ist eine Schaltvorrichtung 24 vorgesehen, die hardwaremäßig aus zwei vom Prozessor 2 gesteuerten elektronischen Schaltern 26 und 27 bestehen kann. Mit dem Schalter 26 kann eine Gleichspannung $U_=$ auf den Anschluss 5 geschaltet werden. Alternativ hierzu könnte auch Leistungsstufe 3 so vom Prozessor 2 angesteuert werden, dass sie statt des Sinussignals eine zeitlich konstante Spannung gegen Masse abgibt, wodurch der Schalter 26 eingespart würde.

Durch Umlegen des Schalters 27, gleichzeitig mit dem Schalter 26, wird der Anschluss 6 über einen Vorwiderstand 25 $R_{LE}$ mit Masse verbunden. Der Vorwiderstand 25 ist im dargestellten Fall in den Massezweig gelegt, der zum Anschluss 6 geschaltet wird; er könnte aber genauso gut in den Zweig zur Gleichspannung $U_=$ gelegt sein, der zum Anschluss 5 geschaltet wird.

Durch Betätigen der Schalter 26 und 27 wird jedenfalls ein Gleichstrom-Stromkreis durch die Leitungen 11 und 12 und die Erregerspule 16 temporär geschlossen.

Der Widerstandswert $R_{LE}$ des Vorwiderstands 25 ist groß im Vergleich zum ohmschen Widerstand $R_E$ der Erregerspule 16 gewählt. Bei unterbrechungsfreiem Erregerleitungen 11 und 12, wenn also der zu diagnostizierende Fehler nicht vorliegt, sind die Anschlüsse 5 und 6 über die Erregerspule 16 niederohmig miteinander verbunden und daher auf nahezu gleichem Potential, da der Spannungsabfall hauptsächlich am Vorwiderstand 25 erfolgt. Liegt hingegen eine Unterbrechung vor, so entsteht der Spannungsabfall zwischen den ersten Anschlüssen 5 und 6 und ist dort als Gleichspannungsdifferenz messbar.

Damit der Prozessor 2 diese Information erhält, sind die ersten Anschlüsse 5 und 6 mit Eingang eines dritten AD-Wandler 23 verbunden, dessen Ausgang dem Prozessor 2 zugeführt wird. Somit erfolgt ein Messen der Spannungsdifferenz $U_E(t_l)$ an den Anschlüssen 5 und 6 der Erregerleitung (Verfahrensschritt 35 in Fig. 2) zu einer Mehrzahl von Zeitpunkten $t_i$ während mindestens einer Erregerperiode, nämlich während der Zeit, für die mittels der Schaltanordnung 24 die Anschlüsse 5 und 6 der Erregerleitungen 11 und 12 mit der Gleichspannung beaufschlagt werden.

Der Prozessor 2 ermittelt aus den Messwerten des AD-Wandlers 23 den Gleichspannungsanteils $U_{E,Offs}$ der Spannungsdifferenz $U_E(t_l)$ zwischen den ersten Anschlüssen 5 und 6 (Verfahrensschritt 36) und stellt fest, dass eine offene Erregerleitung 10 vorliegt, wenn während der Erregerperiode der Gleichspannungsanteil $U_{E,Offs}$ größer als ein zweiter Schwellwert $C_{S2}$ ist. Das Ermitteln des Gleichspannungsanteils kann dabei softwaremäßig in unterschiedlicher Weise erfolgen. Eine Möglichkeit besteht darin, gemäß der Formel

$$U_{E,Offs} = ½ * (\max(U_E(t_i)) + \min(U_E(t_i)))$$

Maximum und Minimum der Gleichspannung der Messwerte im Messintervall zu suchen, und deren Mittelwert ist der Gleichspannungsanteil. Eine weitere Möglichkeit besteht darin, gemäß der Formel

$$U_{E,Offs} = 1/n * \sum U_E(t_i),$$

über alle Messwerte im Messintervall zu mitteln. In beiden Fällen sollte das Messintervall mindestens eine Erregerperiode enthalten.

Auf der Basis der Feststellung, ob der Gleichspannungsanteil $U_{E,Offs}$ größer als der zweite Schwellwert $C_{S2}$ ist oder nicht, und damit, ob eine offene Erregerleitung 10 diagnostiziert wird oder nicht, können die erforderlichen Maßnahmen erfolgen; insbesondere wird das Feststellen des Fehlers mit einer Anzeige- und/oder Speichereinrichtung 9 angezeigt bzw. gespeichert, und die fehlerhafte Leitung wird z.B. mit ihrer Farbe oder Bezugsnummer benannt. In dem Fall, dass die Erregerleitung keine Unterbrechung 10 aufweist, kann insbesondere nach anderen Ursachen für das Ausbleiben des Resolversignals an den zweiten Anschlüssen 7 und 8 geforscht werden.

**Patentansprüche**

1. Verfahren zum Erkennen einer offenen Resolver-Erregerleitung (10) mit folgenden Schritten:

    Messen der Signalspannungen (31) von der Sinus- (17) und der Kosinusspule (18) des Resolvers;
    Vergleichen der durch die Summe der quadrierten Signalspannungen gebildeten Amplitude (32) des Resolversignals mit einem ersten Schwellwert;
    Starten eines Diagnosemodus (33) mit den nachfolgenden Schritten, wenn die gebildete Amplitude den ersten Schwellwert nicht erreicht:

        Beaufschlagen (34) der Anschlüsse (5, 6) der Erregerleitung (11, 12) mit einer konstanten Spannung über einen Vorwiderstand (25), der groß im Vergleich zum ohmschen Widerstand der Erregerspule (16) ist, für die Zeit von mindestens einer Erregerperiode;
        Messen der Spannungsdifferenz (35) an den Anschlüssen (5, 6) der Erregerleitung zu einer Mehrzahl von Zeitpunkten, während die Gleichspannung anliegt; und
        Ermitteln des Gleichspannungsanteils (36) der Spannungsdifferenz; Feststellen (37) einer offenen Erregerleitung (10), wenn während der Erregerperiode der Gleichspannungsanteil größer als ein zweiter Schwellwert ist.

2. Verfahren nach Anspruch 1, wobei das Beaufschlagen (34) durch das Schalten einer Verbindung zu einem Gleichspannungspotential auf den einen Anschluss (5) der Erregerspule und einer Verbindung zu Masse über den Vorwiderstand (25) auf den anderen Anschluss (6) der Erregerspule erfolgt.

3. Verfahren nach Anspruch 1, wobei das Beaufschlagen (34) durch das Ansteuern einer der Endstufen (3, 4) der Erregerschaltung mit einer konstanten Spannung für den einen Anschluss (5) der Erregerspule und durch das Schalten einer Verbindung zu Masse über den Vorwiderstand (25) auf den anderen Anschluss (6) der Erregerspule erfolgt.

4. Verfahren nach einem der Ansprüche 1 bis 3, wobei das Messen der Spannungsdifferenz (35) an den Anschlüssen (5, 6) der Erregerleitungen (11, 12) zu einer Mehrzahl von Zeitpunkten während mindestens einer Erregerperiode erfolgt.

5. Verfahren nach einem der Ansprüche 1 bis 4, wobei das Ermitteln des Gleichspannungsanteils (35) in Abhängigkeit von einer Summe der maximalen und minimalen gemessenen Spannungsdifferenz erfolgt, und beim Bilden der maximalen und minimalen gemessenen Spannungsdifferenz diejenigen Messpunkte berücksichtigt werden, solange eine Gleichspannung anliegt.

6. Verfahren nach einem der Ansprüche 1 bis 4, wobei die Zeitpunkte äquidistant sind, das Ermitteln des Gleichspannungsanteils (35) in Abhängigkeit des Mittelwerts der gemessenen Spannungsdifferenzen, während der eine Gleichspannung anliegt, erfolgt, und wobei die Spannungsdifferenzen über eine Erregerperiode oder ein Vielfaches davon hinweg ermittelt werden.

7. Schaltung zum Erkennen einer offenen Resolver-Erregerleitung (10), aufweisend:

eine Steuervorrichtung (1) mit einem Prozessor (2), Leistungsstufen (3, 4) und ersten Anschlüssen (5, 6) zum Bereitstellen von Signalen für die Erregerleitungen (11, 12) zur Erregerspule (16) des Resolvers (15) und zweiten Anschlüssen (7, 8) zum Anschließen der Signalleitungen (13, 14) für die Signale der Sinus- und der Kosinusspule (17, 18);
zwei AD-Wandler (21, 22), die an die zweiten Anschlüsse (7, 8) der Steuereinrichtung (1) für die Signalleitungen (13, 14) angeschlossen sind und deren Ausgänge von dem Prozessor (2) lesbar und auswertbar sind, wobei der Prozessor (2) dazu ausgestaltet ist, die Verfahrensschritte gemäß Anspruch 1 umzusetzen;
die zu diagnostizierenden Resolver-Erregerleitungen (11, 12), die die ersten Anschlüssen (5, 6) mit der Erregerspule (16) des Resolvers (15) koppeln; und
Signalleitungen (13, 14) für das vom Resolver (15) bereitgestellte Sinus- und Kosinussignal, die den Resolver (15) mit zweiten Anschlüssen (7, 8) der Steuervorrichtung (1) koppeln;
eine vom Prozessor (2) gesteuerte elektronische Schaltanordnung (24) zum temporären Aufschalten einer Gleichspannung auf die ersten Anschlüsse (5, 6) für das Erregersignal über einen Vorwiderstand (25);
einen dritten AD-Wandler (23), der an die ersten Anschlüsse (5, 6) der Steuereinrichtung (1) angeschlossenen ist und dessen Ausgang von dem Prozessor (2) lesbar und auswertbar sind; und
eine Anzeige- und/oder Speichereinrichtung (9) zum Anzeigen und/oder Speichern der vom Prozessor (2) identifizierten Informationen, in die das positive Erkennen einer offenen Leitung (10) der Resolver-Erregerspule (16) einbezogen ist.

8. Schaltung nach Anspruch 7, wobei die elektronische Schaltanordnung (24) einen Schalter (27) umfasst, über den ein Anschluss (6) für die Erregerleitung (11) über einen Vorwiderstand (25) temporär auf Masse schaltbar ist.

9. Schaltung nach Anspruch 7 oder 8, wobei die elektronische Schaltanordnung (24) einen Schalter (26) umfasst, über den ein Anschluss (5) für die Erregerleitung (11) temporär mit einer Gleichspannung gegenüber Masse beaufschlagbar ist.

**Claims**

1. Method for identifying an open resolver exciter line (10), comprising the following steps:

measuring the signal voltages (31) from the sinusoidal coil (17) and the cosinusoidal coil (18) of the resolver;
comparing the amplitude (32) of the resolver signal, which amplitude is formed by the sum of the squared signal voltages, with a first threshold value;
starting a diagnosis mode (33) comprising the following steps if the formed amplitude does not reach the first threshold value:

applying (34) a constant voltage to the connections (5, 6) of the exciter line (11, 12) via a series resistor (25), which is large in comparison to the non-reactive resistance of the exciter coil (16), for the duration of at least one exciter period;
measuring the voltage difference (35) at the connections (5, 6) of the exciter line at a plurality of times while the DC voltage is applied; and
ascertaining the DC voltage component (36) of the voltage difference;
establishing (37) an open exciter line (10) when the DC voltage component is greater than a second threshold value during the exciter period.

2. Method according to Claim 1, wherein the application operation (34) is performed by switching a connection to a DC voltage potential to one connection (5) of the exciter coil and switching a connection to ground via the series resistor (25) to the other connection (6) of the exciter coil.

3. Method according to Claim 1, wherein the application operation (34) is performed by driving one of the output stages (3, 4) of the exciter circuit at a constant voltage for one connection (5) of the exciter coil and by switching a connection to ground via the series resistor (25) to the other connection (6) of the exciter coil.

4. Method according to one of Claims 1 to 3, wherein the voltage difference (35) at the connections (5, 6) of the exciter lines (11, 12 is measured at several times during at least one excitation period.

**5.** Method according to one of Claims 1 to 4, wherein the DC voltage component (35) is ascertained depending on a sum of the maximum and minimum measured voltage difference and, when forming the maximum and minimum measured voltage difference, those measurement points are taken into account provided that a DC voltage is applied.

**6.** Method according to one of Claims 1 to 4, wherein the times are equidistant, the DC voltage component (35) is ascertained depending on the mean value of the measured voltage differences while one DC voltage is applied, and wherein the voltage differences are ascertained over an exciter period or a multiple thereof.

**7.** Circuit for identifying an open resolver exciter line (10), having:

a control apparatus (1) with a processor (2), power stages (3, 4) and first connections (5, 6) for providing signals for the exciter lines (11, 12) to the exciter coil (16) of the resolver (15) and second connections (7, 8) for connecting the signal lines (13, 14) for the signals of the sinusoidal and the cosinusoidal coil (17, 18);
two A/D converters (21, 22) which are connected to the second connections (7, 8) of the control device (1) for the signal lines (13, 14) and the outputs of which can be read and evaluated by the processor (2), wherein the processor (2) is configured to carry out the method steps according to Claim 1;
the resolver exciter lines (11, 12) which are to be diagnosed and couple the first connections (5, 6) to the exciter coil (16) of the resolver (15); and
signal lines (13, 14) for the sinusoidal signal and cosinusoidal signal which are provided by the resolver (15) and couple the resolver (15) to second connections (7, 8) of the control apparatus (1);
an electronic switching arrangement (24), which is controlled by the processor (2), for temporarily connecting a DC voltage to the first connections (5, 6) for the exciter signal via a series resistor (25);
a third A/D converter (23) which is connected to the first connections (5, 6) of the control device (1) and the output of which can be read and evaluated by the processor (2); and
a display and/or storage device (9) for displaying and/or storing the information which is identified by the processor (2) and which includes the positive identification of an open line (10) of the resolver exciter coil (16).

**8.** Circuit according to Claim 7, wherein the electronic switching arrangement (24) comprises a switch (27) by means of which a connection (6) for the exciter line (11) can be temporarily connected to ground via a series resistor (25).

**9.** Circuit according to Claim 7 or 8, wherein the electronic switching arrangement (24) comprises a switch (26) by means of which a DC voltage with respect to ground can be temporarily applied to a connection (5) for the exciter line (11).

## Revendications

**1.** Procédé pour détecter une ligne d'excitation de résolveur ouverte (10) comprenant les étapes suivantes consistant à :

mesurer les tensions de signal (31) de la bobine sinus (17) et de la bobine cosinus (18) du résolveur ;
comparer l'amplitude (32) du signal de résolveur calculé comme étant la somme des tensions au carré du signal à une première valeur seuil ;
lancer un mode de diagnostic (33) lors des étapes suivantes, si l'amplitude calculée n'atteint pas la première valeur seuil :

appliquer (34) une tension constante aux bornes (5, 6) de la ligne d'excitation (11, 12) par l'intermédiaire d'une résistance série (25) dont la valeur est élevée par comparaison à la résistance ohmique de la bobine d'excitation (16) pendant la durée d'au moins une période d'excitation ;
mesurer la différence de tension (35) aux bornes (5, 6) de la ligne d'excitation à une pluralité d'instants pendant que la tension continue est appliquée ; et
déterminer la composante de tension continue (36) de la différence de tension ;
déterminer (37) la présence d'une ligne d'excitation ouverte (10) si, pendant la période d'excitation, la composante de tension continue est supérieure à une deuxième valeur seuil.

**2.** Procédé selon la revendication 1, dans lequel l'application (34) est effectuée par commutation d'une connexion à un potentiel de tension continue sur ladite une borne (5) de la bobine d'excitation et d'une connexion à la masse par l'intermédiaire de la résistance série (25) sur l'autre borne (6) de la bobine d'excitation.

**3.** Procédé selon la revendication 1, dans lequel l'application (34) s'effectue par attaque de l'un des étages de sortie (3, 4) du circuit d'excitation avec une tension constante sur ladite une borne (5) de la bobine d'excitation et par commutation d'une connexion à la masse par l'intermédiaire de la résistance série (25) sur l'autre borne (6) de la bobine d'excitation.

4. Procédé selon l'une des revendications 1 à 3, dans lequel la mesure de la différence de tension (35) aux bornes (5, 6) des lignes d'excitation (11, 12) s'effectue à une pluralité d'instants pendant au moins une période d'excitation.

5. Procédé selon l'une des revendications 1 à 4, dans lequel la détermination de la composante de tension continue (35) s'effectue en fonction d'une somme des différences de tension maximale et minimale mesurées et, lors de la détermination des différences de tension maximale et minimale mesurées, il est tenu compte des points de mesure tant qu'une tension continue est présente.

6. Procédé selon l'une des revendications 1 à 4, dans lequel les instants sont équidistants, la détermination de la composante de tension continue (35) s'effectue en fonction de la valeur moyenne des différences de tension mesurées pendant lesquelles une tension continue est présente et dans lequel les différences de tension sont déterminées au cours d'une période d'excitation ou d'un multiple de celle-ci.

7. Circuit pour détecter une ligne d'excitation de résolveur ouverte (10), comprenant :

un dispositif de commande (1) comportant un processeur (2), des étages de puissance (3, 4) et des premières bornes (5, 6) destinées à fournir des signaux sur les lignes d'excitation (11, 12) à la bobine d'excitation (16) du résolveur (15) et des deuxièmes bornes (7, 8) destinées à raccorder les lignes de signaux (13, 14) destinées aux signaux des bobines sinus et cosinus (17, 18) ;

deux convertisseurs AD (21, 22) qui sont raccordés aux deuxièmes bornes (7, 8) du dispositif de commande (1) sur les lignes de signaux (13, 14) et dont les sorties peuvent être lues et évaluées par le processeur (2), dans lequel le processeur (2) est conçu pour mettre en oeuvre les étapes du procédé selon la revendication 1 ;

les lignes d'excitation de résolveur (11, 12) à diagnostiquer, qui couplent les premières bornes (5, 6) à la bobine d'excitation (16) du résolveur (15) ; et

des lignes de signaux (13, 14) destinées au signaux sinus et cosinus fournis par le résolveur (15), qui couplent le résolveur (15) à des deuxièmes bornes (7, 8) du dispositif de commande (1) ;

un dispositif de commutation électronique (24) commandé par le processeur (2) pour appliquer temporairement une tension continue aux premières bornes (5, 6) destinées au signal d'excitation par l'intermédiaire d'une résistance série (25) ;

un troisième convertisseur AD (23) qui est raccordé aux premières bornes (5, 6) du dispositif de commande (1) et dont la sortie peut être lue et évaluée par le processeur (2) ; et

un dispositif d'affichage et/ou de stockage (9) destiné à afficher et/ou stocker les informations identifiées par le processeur (2), qui comprennent la détection positive d'une ligne ouverte (10) de la bobine d'excitation (16) du résolveur.

8. Circuit selon la revendication 7, dans lequel le dispositif de commutation électronique (24) comprend un commutateur (27) par l'intermédiaire duquel une borne (6) destinée à la ligne d'excitation (11) peut être temporairement commutée à la masse par l'intermédiaire d'une résistance série (25).

9. Circuit selon la revendication 7 ou 8, dans lequel le dispositif de commutation électronique (24) comprend un commutateur (26) par l'intermédiaire duquel une tension continue par rapport à la masse peut être temporairement appliquée à une borne (5) de la ligne d'excitation (11).

**Fig. 1**

EP 3 311 107 B1

EP 3 311 107 B1

Fig. 2

9

**IN DER BESCHREIBUNG AUFGEFÜHRTE DOKUMENTE**

**In der Beschreibung aufgeführte Patentdokumente**

- DE 102011078583 A1
- JP 2012098188 B